# EUROPEAN PATENT SPECIFICATION

(11) **EP 2 038 668 B1**
(45) Date of publication and mention of the grant of the patent: **29.12.2010**
(21) Application number: 07766752.5
(22) Date of filing: 14.06.2007
(51) Int. Cl.: G01R 31/30

(54) **SEMICONDUCTOR DEVICE WITH TEST STRUCTURE AND SEMICONDUCTOR DEVICE TEST METHOD**
HALBLEITERBAUELEMENT MIT TESTSTRUKTUR UND TESTVERFAHREN FÜR EIN HALBLEITERBAUELEMENT
DISPOSITIF À SEMI-CONDUCTEURS AVEC STRUCTURE DE TEST ET PROCÉDÉ DE TEST DU DISPOSITIF À SEMI-CONDUCTEURS

(30) Priority: 20.06.2006 EP 06115740
(43) Date of publication of application: 25.03.2009
(73) Proprietor: NXP B.V., 5656 AG Eindhoven (NL)
(72) Inventor: PELGROM, Marcel, Redhill Surrey RH1 5HA (GB); PETRESCU, Violeta, Redhill Surrey RH1 5HA (GB); THEENDAKARA, Praveen, 5656 AG Eindhoven (NL)
(74) Representative: Williamson, Paul Lewis
(86) International application number: PCT/IB2007/052268
(87) International publication number: WO 2007/148268

(56) References cited:
- EP-A- 1 394 943
- US-A1- 2005 134 394
- US-B1- 6 272 666

## Description

The present invention relates to a semiconductor device comprising a test structure for detecting variations in the structure of the semiconductor device, the test structure comprising a first supply rail, a second supply rail and a ring oscillator coupled between the first supply rail and second supply rail, the ring oscillator having an output for providing a test result signal.

The present invention further relates to a method for testing such a semiconductor device.

The minitiaturization of the feature size on semiconductor devices such as integrated circuits (ICs) has facilitated the integration of large number of elements such as transistors on the device. However, this has come at the cost of increased sensitivity of the device to for instance (manufacturing) process variations, which may lead to the malfunctioning of the semiconductor device. Even if the device does not malfunction after manufacture, ageing of the device can still cause such a malfunction if the aforementioned variations were close to the allowable thresholds at manufacture. This will increasingly become an issue because of the further reduction of feature sizes in future semiconductor technologies.

One of those problems is the variation in the threshold voltage (Vₜₕ) between respective transistors. Such variations may have various reasons, such as variations in doping levels, poor annealing, excessive rework of the wafer, packaging induced damage and so on. The variation of the threshold levels can for instance cause failure in the assignment of the correct binary value to a signal extracted from a transistor because of an excessive deviation of the transistor output voltage from the intended value because of the Vₜₕ mismatch.

A solution to this problem is disclosed in US patent US 6,272,666, in which an integrated circuit is described that has multiple domains of groups of transistors. Each domain, i.e. each group of transistors, is provided with performance detection circuitry based on a ring oscillator having an odd number of inverter stages for determining the average speed of the transistors in the domain. A biasing voltage is derived from the determined average speed for each domain to compensate for variations in the average speeds between domains. However, this solution can only detect and compensate for mismatches between different groups of transistors, and is not capable to detect local Vₜₕ mismatches between transistors within the same domain, e.g. neighbouring transistors. This is a drawback, because such mismatches can be substantial; for instance, in present CMOS technologies, local Vₜₕ mismatches of up to 80mV have been detected.

EP 1 394 943 A2 discloses a ring oscillator for a test apparatus and method for verifying fabrication of transistors in an integrated circuit on a die under test. The ring oscillator is fabricated on the die and includes a positive feedback loop between a circuit output terminal and a feedback input terminal. The feedback loop includes a plurality of delaying stages connected in cascade. A transfer gate is coupled to each delaying stage. Each of the transfer gates includes a pair of transistors of the first and second conductivity types connected in parallel.

### SUMMARY OF THE INVENTION

The present invention seeks to provide a semiconductor device that has a test structure that can detect such local mismatches.

The present invention further seeks to provide a method for testing such a semiconductor device.

According to a first aspect of the present invention, there is provided a semiconductor device comprising a test structure for detecting variations in the structure of the semiconductor device, the test structure comprising a first supply rail, a second supply rail, a ring oscillator coupled between the first supply rail and second supply rail, the ring oscillator having an output for providing a test result signal, and an array of individually controllable transistors coupled in parallel between the first supply rail and the ring oscillator.

The test structure, which may be integrated in an IC or placed on a wafer carrying a plurality of ICs, facilitates the determination of structural variations by having individually controllable transistors coupled between the ring oscillator and a power supply rail. By selectively activating the transistors under predefined bias conditions, the behaviour of each transistor can be determined and compared with its neighbouring transistors. This gives an indication of the magnitude of the Vₜₕ mismatch, i.e. the Vth variation, in the array. Because this mismatch typically is caused by an effect to which the whole semiconductor device has been exposed, the mismatch is indicative for local variations, e.g. variations between neighbouring transistors, of the semiconductor device. The inclusion of the test structure of the present invention has the further advantage that post-manufacturing induced mismatches such as mismatches introduced by the packaging of the semiconductor device can be determined without having to remove the device from its package.

The test structure may comprise further array of individually controllable transistors coupled in parallel between the second supply rail and the ring oscillator, which may be realized in a different technology than the first transistor array, e.g. pMOS and nMOS arrays. This has the advantage that the variations of more than one device type used on the semiconductor device can be estimated with a single test structure.

Preferably, this embodiment further comprises a first switch coupled between the ring oscillator and the first supply rail for bypassing the array of individually controllable transistors; and a second switch coupled between the ring oscillator and the second supply rail for bypassing the further array of individually controllable transistors to facilitate testing each array in isolation.

The output of the ring oscillator may be made available to the outside world via an output of the semiconductor device to facilitate external retrieval of the test results. Alternatively, the ring oscillator output may be retrieved by an internal measurement system such as the system disclosed in WO 2006/056951-A1 assigned to the applicant of the present application.

According to another aspect of the present invention, there is provided a method of testing a semiconductor device of the present invention, the method comprising:
(a) enabling a subset of the transistors in the array under predefined bias conditions;
(b) determining a first frequency of the ring oscillator;
(c) enabling a further subset of the transistors in the array under the predefined bias conditions;
(d) determining a second frequency of the ring oscillator; and
(e) comparing the first frequency with the second frequency.

This method provides an estimation of local mismatches in such a semiconductor device.

Preferably, the method further comprises modifying the predefined bias conditions; and repeating the steps (a)-(e). This way, the full operating range of the transistors in the array can be determined. Moreover, using different bias conditions enables distinguishing between threshold and current factor contributions.

### DETAILED DESCRIPTION

The invention is described in more detail and by way of non-limiting examples with reference to the accompanying drawings, wherein:
Fig.1 depicts an aspect of a semiconductor device of the present invention;
Fig.2 depicts an aspect of a further semiconductor device of the present invention; and
Fig.3 depicts a flowchart of an embodiment of the method of the present invention.

It should be understood that the Figures are merely schematic and are not drawn to scale. It should also be understood that the same reference numerals are used throughout the Figures to indicate the same or similar parts.

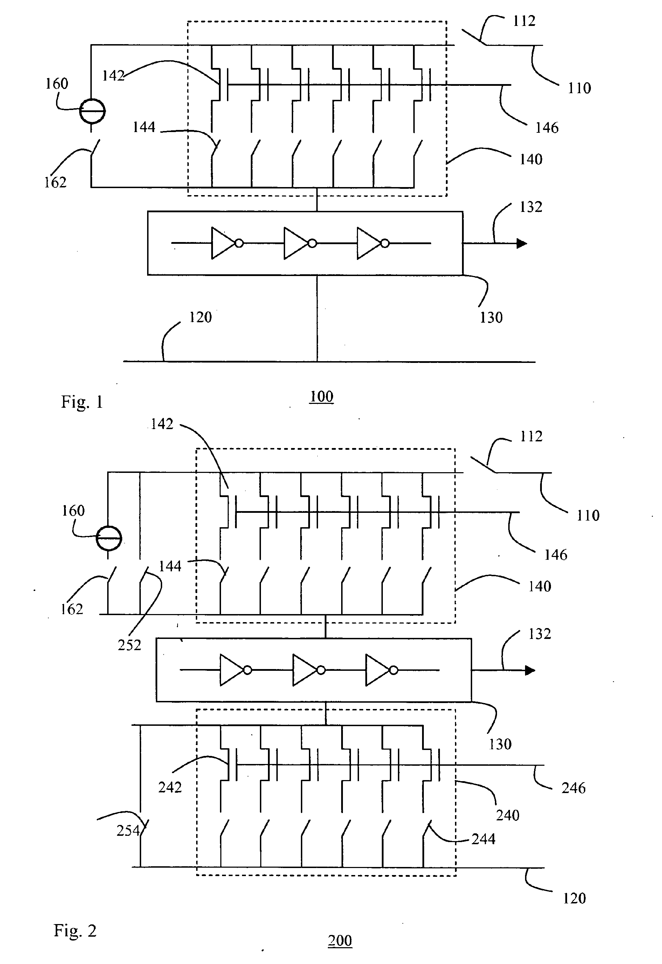

In Fig. 1, a semiconductor device, which may be an IC or a wafer carrying a number of ICs, has a test structure 100 that includes a ring oscillator 130 coupled between a first supply rail 110 and a second supply rail 120. The ring oscillator 130 has an output 132 at which the output frequency of the ring oscillator 130 is provided. The output 132 may be coupled to an output pin (not shown) of the semiconductor device. The conductive coupling between the first supply rail 110 and the ring oscillator 130 comprises an array 140 of transistors 142. The transistors 142 may be realized in any suitable technology, such as but not limited to CMOS technology. Also, the transistors 142 do not necessarily have to have the same dimensions. This will depend on the specific effect the test structure is intended to measure. The transistors 142 can be individually controlled and are arranged such that a bias voltage can be applied to them. In Fig. 1, this is realized by providing a bias voltage via the control line 146 to the control terminals of the transistors 142 and by including individually controllable switches 144 to select individual transistors 142, but it will be appreciated that this is by way of mere example only. Other implementations, such as a bias provided to e.g. the substrate of transistors 142 and selecting individual transistors 142 via their control terminals, thus obviating the need for separate switches 144, is equally feasible, and various alternatives will be apparent to the skilled person.

At this point, it is emphasized that the transistors 142 of the array may be a part of a larger semiconductor structure. For instance, small groups of transistors, as they may occur in the main function of the semiconductor device, can be used. Examples of such structures are a transistor 142 with a cascode device (not shown), a short circuited inverter (not shown) and a memory cell (not shown). Other examples will be apparent to the skilled person. Moreoever, it should be understood that at least 2 but more likely 10-30 transistors 142 will be included in array 140 to enable statistical evaluation with sufficient confidence levels.

The test structure 100 may be enabled by a test enable signal controlling a switch 112 in the first supply rail 110. The transistors 142 may be selected via dedicated selection lines (not shown), which may be configured via an internal state machine responsive to the test enable signal or via externally provided configuration data, which may be provided via a (boundary scan compliant) shift register. Optionally, the test structure 100 may also comprise a calibration current source 160 that may be selected via switch 162 for calibrating the ring oscillator 130 to facilitate a more quantitative analysis of the variation in the behaviour of respective transistors 142.

Fig. 2 shows a test structure 200, which has some additional features compared to test structure 100. In particular, the test structure 200 comprises a further array 240 of individually controllable transistors 242, e.g. via switches 244, which can be provided with a further bias voltage, e.g. via control line 246. The aforementioned alternative arrangements for selecting and biasing the transistors 142 are equally applicable to the transistors 242. The further array 240 is conductively coupled between the ring oscillator 130 and the further supply rail 120. The test structure 200 further comprises bypass switches 252 and 254 for bypassing, or shorting, the array 140 and the further array 240 respectively to facilitate selection of transistors from a single array in isolation. The array 140 and the further array 240 may comprise different transistors 142 and 242; e.g. the transistors 142 may be realized in a different technology compared to transistors 242. For instance, transistors 142 may be nMOS transistors and transistors 242 may be pMOS transistors. Other examples are also feasible.

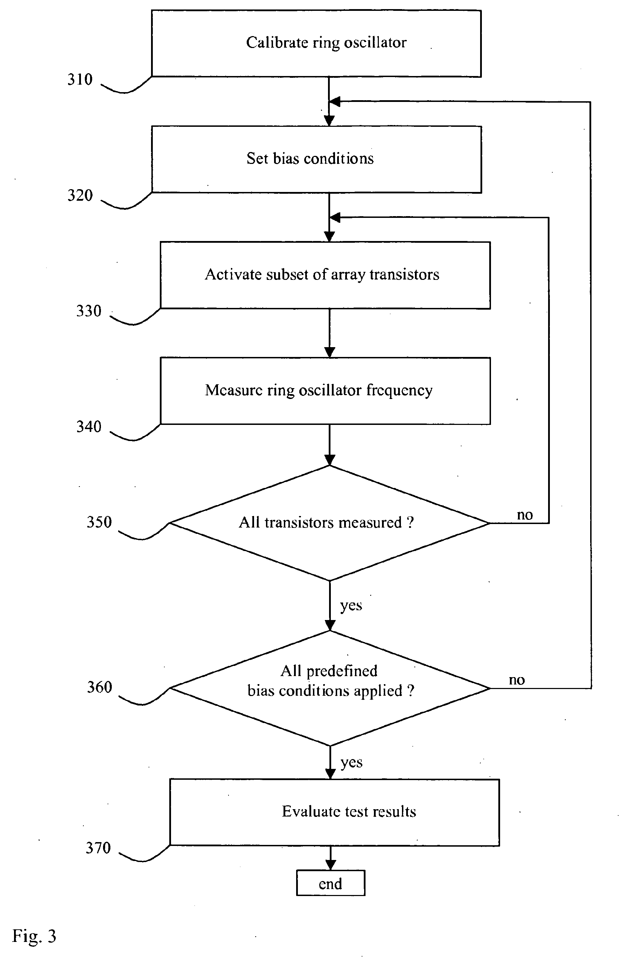

The operation and purpose of the test structure 100 and the test structure 200 will be explained in more detail with the aid of Fig. 3, which depicts a flowchart of an embodiment of the method of the present invention. The test structures 100 and 200 target the detection of manufacturing or processing induced variations that can cause differences in behaviour between transistors that are located in close proximity of each other. Typically, if such variations occur, substantial areas of the semiconductor device may be affected thereby. The placement of a test structure 100 or 200 on the semiconductor device serves as an indicator for the occurrence of such variations, which can help to identify unreliable or even faulty semiconductor devices.

Examples of events that can cause such variations include but are not limited to fundamental mechanisms such as doping concentration fluctuations over the semiconductor device, which lead to varying conductivities, poor annealing, slipping away of technology, interface states introduced by an ionimplantation step, excessive rework of the wafer leading to damage and so on. In addition, when monitoring variations due to doping concentration fluctuation and stress related mobility degradation, the transistors 142 can be surrounded by structures typical for generating the specific conditions, such as metal wires or so called shallow trenches.

In case only part of the semiconductor device has suffered from such variations, more than one test structure may be placed on different parts of the semiconductor device to increase the chance of detecting such variations.

The variations can be detected as follows. A bias voltage is applied to the selected array of transistors, e.g. array 140 of transistors 142 in a first step 320, after which in step 330 a subset of the transistors, e.g. a single transistor, is activated to conductively couple the subset to the ring oscillator 130. This will cause the ring oscillator 130 to produce a frequency that is dependent on the effective current running through the selected transistor 142. The effective current is dependent of the threshold voltage (Vₜₕ) of the transistor, with Vₜₕ being sensitive to at least some of the aforementioned variations. The ring oscillator frequency is measured in step 340.

The steps 330 and 340 are repeated until a frequency measurement for all transistors of the array has been performed, as checked in step 350. The frequencies are compared to each other in step 370. Because the output frequencies of the ring oscillator 130 are correlated to the Vₜₕ of the selected transistors, a spread in the frequencies obtained in respective steps 340 allows for the determination of a qualitative indication of the magnitude of the Vₜₕ mismatch between the transistors as caused by the aforementioned variations.

For more accurate test results, the ring oscillator 130 may be calibrated in an optional step 310 prior to the frequency determinations of the individual array transistors. To this end, the current source 160, which is configured to (selectively) produce one (or more) reference current(s) **(I_{ref}),** is conductively coupled to the ring oscillator by activating switch 162. The frequency output of the ring oscillator in response to I_{ref} is used as a reference frequency in the evaluation of the frequencies obtained from the array transistors.

At this point, it is emphasized that variations in the currents through the array transistors may also be caused by current factor contributions. To discriminate between Vₜₕ mismatches and current factor contributions, the current output of the individual transistors may be measured a number of times under different predefined bias voltage conditions, as set in optional step 360.

It will be obvious that in the case of test structure 200, the arrays 140 and 240 can be separately tested. In this case, if the current output of the transistors 142 of array 140 is measured, the bypass switch 254 is activated to bypass the array 240, whereas if the current output of the transistors 242 of array 240 is measured, the bypass switch 252 is activated to bypass the array 140. This way, the effect of the aforementioned variations on different technologies, e.g. pMOS and nMOS technologies can be determined.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A semiconductor device comprising a test structure (100, 200) for detecting variations in the structure of the semiconductor device, the test structure (100, 200) comprising:
a first supply rail (110);
a second supply rail (120); and
a ring oscillator (130) coupled between the first supply rail (110) and second supply rail (120), the ring oscillator (130) having an output (132) for providing a test result signal;
**characterized by**:
an array (140) of individually controllable transistors (142), the transistors being coupled in parallel between the first supply rail (110) and the ring oscillator (130).

2. A semiconductor device as claimed in claim 1, further comprising a further array (240) of individually controllable transistors (242), the transistors of the further array being coupled in parallel between the second supply rail (120) and the ring oscillator (130).

3. A semiconductor device as claimed in claim 2, wherein the transistors (142; 242) of the array (140) and the further array (240) respectively are realized in different technologies.

4. A semiconductor device as claimed in claim 2 or 3, further comprising:
a first switch (252) coupled between the ring oscillator (130) and the first supply rail (110) for bypassing the array (140) of individually controllable transistors (142); and
a second switch (254) coupled between the ring oscillator (130) and the second supply rail (120) for bypassing the further array (240) of individually controllable transistors (242).

5. A semiconductor device as claimed in any of claims 1-4, further comprising a test output coupled to the output (132) of the ring oscillator (130).

6. A semiconductor device as claimed in any of claims 1-5, wherein the semiconductor device comprises an integrated circuit comprising the test structure (100, 200).

7. A semiconductor device as claimed in any of claims 1-5, wherein the semiconductor device comprises a wafer carrying a plurality of integrated circuits.

8. A method of testing a semiconductor device as claimed in claim 1, comprising:
(a) enabling a subset of the transistors (142, 242) in the array (140, 240) under predefined bias conditions;
(b) determining a first frequency of the ring oscillator (130);
(c) enabling a further subset of the transistors (142, 242) in the array (140, 240) under the predefined bias conditions;
(d) determining a second frequency of the ring oscillator (130); and
(e) comparing the first frequency with the second frequency.

9. A method as claimed in claim 8, further comprising:
modifying the predefined bias conditions; and
repeating the steps (a)-(e).

10. A method as claimed in claim 8 or 9, further comprising calibrating the ring oscillator (130) prior to the first execution of step (a).

## Patentansprüche

1. Halbleitervorrichtung enthaltend eine Teststruktur (100, 200) zum Detektieren von Variationen in der Struktur der Halbleitervorrichtung, die Teststruktur (100, 200) enthaltend:
eine erste Versorgungsschiene (110);
eine zweite Versorgungsschiene (120); und
einen Ringoszillator (130), welcher zwischen die erste Versorgungsschiene (110) und die zweite Versorgungsschiene (120) gekoppelt ist, wobei der Ringoszillator (130) einen Ausgang (132) zum Bereitstellen eines Testergebnissignals aufweist;
**gekennzeichnet durch**:
ein Array (140) von einzeln steuerbaren Transistoren (142), wobei die Transistoren parallel zwischen der ersten Versorgungsschiene (110) und dem Ringoszillator (130) gekoppelt sind.

2. Halbleitervorrichtung nach Anspruch 1, ferner enthaltend ein weiteres Array (240) von einzeln steuerbaren Transistoren (242), wobei die Transistoren des weiteren Arrays parallel zwischen die zweite Versorgungsschiene (120) und den Ringoszillator (130) gekoppelt sind.

3. Halbleitervorrichtung nach Anspruch 2, wobei die Transistoren (142; 242) des Arrays (140) und des weiteren Arrays (240) in jeweils verschiedenen Technologien realisiert sind.

4. Halbleitervorrichtung nach Anspruch 2 oder 3, ferner enthaltend:
einen ersten Schalter (252), welcher zwischen den Ringoszillator (130) und die erste Versorgungsschiene (110) gekoppelt ist zum Umgehen des Arrays (140) von einzeln steuerbaren Transistoren (142); und
einen zweiten Schalter (254), welcher zwischen den Ringoszillator (130) und die zweite Versorgungsschiene (120) gekoppelt ist zum Umgehen des weiteren Arrays (240) von einzeln steuerbaren Transistoren (242).

5. Halbleitervorrichtung nach einem der Ansprüche 1 bis 4, ferner enthaltend einen Testausgang, welcher an den Ausgang (132) des Ringoszillators (130) gekoppelt ist.

6. Halbleitervorrichtung nach einem der Ansprüche 1 bis 5, wobei die Halbleitervorrichtung eine integrierte Schaltung aufweisend die Teststruktur (100, 200) aufweist.

7. Halbleitervorrichtung nach einem der Ansprüche 1 bis 5, wobei die Halbleitervorrichtung einen Wafer aufweist, welcher eine Vielzahl von integrierten Schaltungen trägt.

8. Verfahren des Testens einer Halbleitervorrichtung nach Anspruch 1, enthaltend:
(a) Freigeben einer Untermenge der Transistoren (142, 242) in dem Array (140, 240) unter vordefinierten Biasbedingungen;
(b) Bestimmen einer ersten Frequenz des Ringoszillators (130);
(c) Freigeben einer weiteren Untermenge der Transistoren (142, 242) in dem Array (140, 240) unter den vorbestimmten Biasbedingungen;
(d) Bestimmen einer zweiten Frequenz des Ringoszillators (130); und
(e) Vergleichen der ersten Frequenz mit der zweiten Frequenz.

9. Verfahren nach Anspruch 8, ferner enthaltend:
Modifizieren der vorbestimmten Biasbedingungen; und
Wiederholen der Schritte (a) - (e).

10. Verfahren nach Anspruch 8 oder 9, ferner enthaltend ein Kalibrieren des Ringoszillators (130) vor der ersten Ausführung von Schritt (a).

## Revendications

1. Dispositif semi-conducteur comprenant une structure de test (100, 200) pour la détection des variations dans la structure du dispositif semi-conducteur, la structure de test (100, 200) comprenant :
un premier rail d'alimentation (110) ;
un deuxième rail d'alimentation (120) ; et
un oscillateur en anneau (130) raccordé entre le premier rail d'alimentation (110) et le deuxième rail d'alimentation (120), l'oscillateur en anneau (130) ayant une sortie (132) pour fournir un signal de résultat de test ;
**caractérisé par** :
une matrice (140) de transistors commandables individuellement (142), les transistors étant raccordés en parallèle entre le premier rail d'alimentation (110) et l'oscillateur en anneau (130).

2. Dispositif semi-conducteur selon la revendication 1, comprenant en outre une autre matrice (240) de transistors commandables individuellement (242), les transistors de l'autre matrice étant raccordés en parallèle entre le deuxième rail d'alimentation (120) et l'oscillateur en anneau (130).

3. Dispositif semi-conducteur selon la revendication 2, dans lequel les transistors (142 ; 242) de la matrice (140) et respectivement de l'autre matrice (240) sont réalisés dans des technologies différentes.

4. Dispositif semi-conducteur selon les revendications 2 ou 3, comprenant en outre :
un premier commutateur (252) raccordé entre l'oscillateur en anneau (130) et le premier rail d'alimentation (110) pour réaliser une dérivation de la matrice (140) de transistors commandables individuellement (142) ; et
un deuxième commutateur (254) raccordé entre l'oscillateur en anneau (130) et le deuxième rail d'alimentation (120) pour réaliser une dérivation de l'autre matrice (240) de transistors commandables individuellement (242).

5. Dispositif semi-conducteur selon l'une quelconque des revendications 1 à 4, comprenant en outre une sortie de test raccordée à la sortie (132) de l'oscillateur en anneau (130).

6. Dispositif semi-conducteur selon l'une quelconque des revendications 1 à 5, dans lequel le dispositif semi-conducteur comprend un circuit intégré comprenant la structure de test (100, 200).

7. Dispositif semi-conducteur selon l'une quelconque des revendications 1 à 5, dans lequel le dispositif semi-conducteur comprend une tranche supportant une pluralité de circuits intégrés.

8. Procédé de test d'un dispositif semi-conducteur selon la revendication 1, comprenant :
(a) l'activation d'un sous-ensemble des transistors (142, 242) dans la matrice (140, 240) dans des conditions de polarisation prédéfinies ;
(b) la détermination d'une première fréquence de l'oscillateur en anneau (130) ;
(c) l'activation d'un autre sous-ensemble de transistors (142, 242) dans la matrice (140, 240) dans les conditions polarisation prédéfinies ;
(b) la détermination d'une deuxième fréquence de l'oscillateur en anneau (130) ; et
(e) la comparaison de la première fréquence avec la deuxième fréquence.

9. Procédé selon la revendication 8, comprenant en outre :
la modification des conditions de polarisation prédéfinies ; et
la répétition des étapes (a)-(e).

10. Procédé selon les revendications 8 ou 9, comprenant en outre l'étalonnage de l'oscillateur en anneau (130) avant la première exécution de l'étape (a).
